Europäisches Patentamt
European Patent Office
Office européen des brevets

(19)

(11) Veröffentlichungsnummer: **0 285 014 A2**

(12) **EUROPÄISCHE PATENTANMELDUNG**

(21) Anmeldenummer: **88104800.3**

(51) Int. Cl.⁴: **G03F 7/08**

(22) Anmeldetag: **25.03.88**

(30) Priorität: **03.04.87 DE 3711263**

(43) Veröffentlichungstag der Anmeldung:
**05.10.88 Patentblatt 88/40**

(84) Benannte Vertragsstaaten:
**AT BE CH DE FR GB IT LI NL**

(71) Anmelder: **HOECHST AKTIENGESELLSCHAFT**
**Postfach 80 03 20**
**D-6230 Frankfurt am Main 80(DE)**

(72) Erfinder: **Stahlhofen, Paul, Dr. Dipl.-Chem.**
**Leibnizstrasse 18/b**
**D-6200 Wiesbaden(DE)**

(54) **Lichtempfindliches Gemisch, daraus hergestelltes Kopiermaterial und Verfahren zur Herstellung von Druckformen.**

(57) Es wird ein lichtempfindliches Gemisch, ein hiermit hergestelltes Kopiermaterial und die Herstellung von negativen Reliefkopien beschrieben, bei dem ein lichtempfindliches Material, das als lichtempfindliche Verbindung einen Ester oder ein Amid einer 1,2-Chinondiazidsulfonsäure oder -carbonsäure, Bindemittel und ein s-Triazin der allgemeinen Formel I

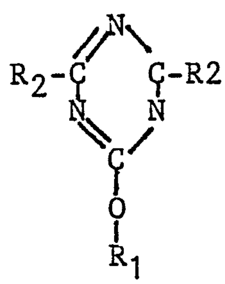

worin $R_1$ Alkyl oder Aryl und
$R_2$ Alkoxy, Aryloxy oder eine durch Alkyl, Cycloalkyl oder Aryl mono-oder disubstituierte Aminogruppe sein können,

enthält, bildmäßig unter einer Negativ-Vorlage belichtet, dann erwärmt, nach dem Abkühlen ohne Vorlage oder gegebenenfalls unter einer Positiv-Vorlage belichtet und dann mittels eines wäßrig-alkalischen Entwicklers entwickelt wird.

EP 0 285 014 A2

# Lichtempfindliches Gemisch, daraus hergestelltes lichtempfindliches Kopiermaterial und Verfahren zur Herstellung von Druckformen

Die Erfindung betrifft ein lichtempfindliches Gemisch, das im wesentlichen ein wasserunlösliches, in wäßrig-alkalischen Lösungen lösliches Bindemittel, ein lichtempfindliches 1,2-Chinondiazid oder ein lichtempfindliches Gemisch aus einer bei Belichtung Säure abspaltenden Verbindung und einer Verbindung mit mindestens einer durch Säure spaltbaren C-O-C-Gruppe und eine thermische Härtung fördernde Substanz enthält. Die Erfindung betrifft auch ein hieraus hergestelltes Kopiermaterial aus einem Schichtträger und einer lichtempfindlichen Schicht, die aus dem Gemisch besteht, sowie Verfahren zur Herstellung von negativen Reliefkopien durch Belichten, Erwärmen, vollflächiges Belichten, Entwickeln und gegebenenfalls Erhitzen des Kopiermaterials zwecks Erhöhung der Druckauflage.

Lichtempfindliche Gemische, deren bildmäßig belichtete Bereiche in einer Entwicklerlösung löslich werden und deren unbelichtete Bereiche unlöslich sind, sind seit langem bekannt. Für die Herstellung derartiger Materialien werden in der Praxis vor allem Schichten mit o-Chinondiaziden als lichtempfindliche Verbindungen verwendet, die noch Harze mit alkalilöslich machenden Gruppen enthalten, z.B. Phenolharze.

Lichtempfindliche Gemische auf Basis säurespaltbarer Ver bindungen sind ebenfalls bekannt. Sie enthalten als säurespaltbare Verbindungen Orthocarbonsäurederivate, monomere oder polymere Acetale, Enolether oder Acyliminocarbonate. Als strahlungsempfindliche, Säure abspaltende Verbindungen enthalten sie vorwiegend organische Halogenverbindungen, insbesondere durch Halogenmethylgruppen substituierte s-Triazine. Als Bindemittel werden auch Harze mit alkalilöslich machenden Gruppen verwendet.

Es ist auch bekannt, daß ein normalerweise positiv arbeitendes Kopiermaterial auf Basis von o-Chinondiaziden in Gegenwart geeigneter Zusatzstoffe durch eine bestimmte Folge von Behandlungen negativ verarbeitet werden kann. In der GB-A 2,082,339 ist ein derartiges Umkehrverfahren beschrieben, bei dem ein lichtempfindliches Gemisch, bestehend aus einem o-Chinondiazid und mindestens einem Resol, als negativ arbeitendes Aufzeichnungsmaterial benutzt werden kann. In der DE-A 25 29 054 entsprechend US-A 4,104,070 werden Resistschichten auf Basis von 1,2-Chinondiaziden für ein Umkehrverfahren beschrieben, die als Zusatzstoff Hydroxyethylimidazoline enthalten. Ein ähnliches Material mit einem Gehalt an sekundären oder tertiären Aminen wird in der US-A 4,196,003 beschrieben. In EP-A 0 133 216 entsprechend US-A 4,581,321 wird ein Umkehrverfahren beschrieben, welches als Zusatz zur o-Chinondiazid-haltigen Kopierschicht einen Hexamethylolmelaminether enthält, der vorzugsweise als Vernetzungsmittel bei Polymerreaktionen Verwendung findet, während in EP-A 0 131 238 entsprechend US-A 4,576,901 ein Umkehrverfahren beschrieben wird, dessen lichtempfindliches Material keinen der oben erwähnten basischen oder sauren Zusätze erfordert.

Bekannt ist ferner ein Positiv-Negativ-Umkehrverfahren auf Basis säurespaltbarer Verbindungen anstelle von 1,2-Chinondiaziden, wie es in EP-A 0 082 463 entsprechend US-A 4,506,006 beschrieben ist.

Die beschriebenen Umkehrverfahren enthalten im Prinzip die gleiche Folge von Verarbeitungsschritten, wobei nach der bildmäßigen Belichtung die Druckplatte erwärmt wird, nach dem Abkühlen nochmals ohne Vorlage nachbelichtet und dann mittels eines wäßrig-alkalischen Entwicklers entwickelt wird.

Die bekannten Umkehrverfahren beruhen darauf, daß die entstandenen Lichtzersetzungsprodukte beim Erwärmen ein unlösliches Reaktionsprodukt ergeben. Diese thermische Härtung erfolgt vorzugsweise in Gegenwart bestimmter basischer oder saurer Zusätze zur Kopierschicht oder in Gegenwart bestimmter Vernetzungsmittel mit multifunktionalen reaktionsfähigen Gruppen.

Derartige Zusätze haben jedoch im allgemeinen einen nachteiligen Einfluß auf die Lagerfähigkeit des Kopiermaterials und auf bestimmte kopiertechnische Eigenschaften, wie z.B. die Lichtempfindlichkeit und den Bildkontrast nach dem Belichten. Auch ist für viele Anwendungszwecke die zur Bildumkehr erforderliche Temperatur zu hoch oder die Dauer des Erhitzens bei niedrigerer Temperatur zu lang oder der Umkehrspielraum ist zu klein.

Das in EP-A-0 133 216 beschriebene Umkehrverfahren enthält wie bereits erwähnt, als wesentlichen Bestandteil in der Kopierschicht neben einem 1,2-Chinondiazid einen Ether des Hexamethylolemelamins. Obwohl derartige Melaminether die Bildumkehr eines normalerweise positiv arbeitenden lichtempfindlichen Materials während der thermischen Behandlung an den belichteten Bildbereichen in vorteilhafter Weise fördern, haben derartige Hexamethylolmelaminether jedoch den Nachteil, daß die Temperaturtoleranzen des Umkehrspielraumes relativ gering sind, wodurch es zu unterschiedlichen Kopierergebnissen kommen kann. Ein weiterer großer Nachteil ist die mangelhafte

Lagerfähigkeit der Druckplatten infolge der reaktionsfähigen $-CH_2-O-R$-Gruppen der Zusatzverbindung, insbesondere bei erhöhten Temperaturen, was zu einer vorzeitigen Vernetzung und Unbrauchbarkeit führt.

Aufgabe der Erfindung war es deshalb, ein lichtempfindliches Gemisch, ein hieraus hergestelltes Kopiermaterial und ein Umkehrverfahren mittels dieses Materials zu schaffen, das die oben erwähnten Nachteile nicht besitzt, sondern eine gute Lagerfähigkeit auch bei angehobener Temperatur besitzt und einen relativ hohen Spielraum in der thermischen Behandlung aufweist.

Gegenstand der Erfindung ist ein lichtempfindliches Gemisch, das im wesentlichen ein wasserunlösliches, in wäß rig-alkalischen Lösungen lösliches Bindemittel, ein lichtempfindliches 1,2-Chinondiazid oder ein lichtempfindliches Gemisch aus einer bei Belichtung Säure abspaltenden Verbindung und einer Verbindung mit mindestens einer durch Säure spaltbaren C-O-C-Gruppe und eine thermische Härtung fördernde Substanz enthält, dadurch gekennzeichnet, daß als thermische Härtung fördernde Substanz eine Verbindung der allgemeinen Formel I

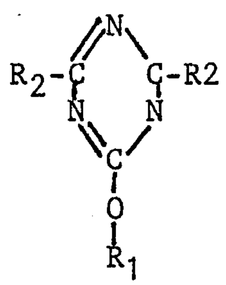

worin $R_1$ Alkyl oder Aryl und
$R_2$ Alkoxy, Aryloxy oder eine durch Alkyl, Cycloalkyl oder Aryl mono-oder disubstituierte Aminogruppe sein können,

vorhanden ist. Als thermische Härtung fördernde Substanz wird vorzugsweise eine Verbindung der allgemeinen Formel I eingesetzt, in welcher

$R_1$ $(C_1-C_4)$-Alkyl oder Phenyl und
$R_2$ $(C_1-C_4)$-Alkoxy, Phenoxy oder eine durch $(C_1-C_4)$-Alkyl, $(C_4-C_8)$-Cycloalkyl mono-oder disubstituierte Aminogruppe sein können.

Als besonders vorteilhaft einsetzbar hat sich 2-Dialkylamino-4,6-dialkoxy-s-triazin erwiesen.

Die Herstellung der erfindungsgemäß eingesetzten s-Triazine ist beispielsweise in "The Journal of the American Chemical Society", Vol. 73 (1951), Seite 2986 - 2992 beschrieben.

Die Konzentration der s-Triazine in dem lichtempfindlichen Gemisch kann in relativ weiten Grenzen schwanken. Im allgemeinen liegt der Anteil bei 0,5 bis 30, vorzugsweise zwischen 1 und 15 Gewichtsprozen, bezogen auf das Gewicht der nicht-flüchtigen Bestandteile des lichtempfindlichen Gemisches.

Von großem Vorteil ist, daß die erfindungsgemäß eingesetzten symmetrischen Triazine dem lichtempfindlichen Gemisch und dem damit hergestellten Kopiermaterial während des Positiv-Negativ-Umkehrschrittes eine gute Beständigkeit gegenüber unerwünschter Wärmeeinwirkung verleihen. Hieraus resultiert ein relativ großer Umkehrspielraum während der Wärmebehandlung, ohne daß hierbei die Tonwertwiedergabe auch bei Temperaturschwankungen während des Umkehrschrittes nachteilig beeinflußt wird. Dies führt zu einer erheblichen Erleichterung der Verfahrensweise zur Herstellung von Druckformen.

Brauchbare Sensibilisatoren, die in dem erfindungsgemäßen Gemischbzw. dem daraus hergestellten Kopiermaterial verwendet werden können, sind alle 1,2-Chinondiazidsulfon säureester, 1,2-Chinondiazid-sulfonsäureamide, 1,2-Chinondiazid-carbonsäureester und -amide, die nach dem Bestrahlen mit aktinischem Licht in wäßrig-alkalischen Lösungen löslich werden. Hierzu zählen die Umsetzungsprodukte von 1,2-Benzo-oder 1,2-Naphthochinon-diazid-4-oder -5-sulfonsäure bzw. von deren Säurechloriden mit Phenol-Aldehyd/Aceton-Kondensationsprodukten oder Poly-meren aus p-Hydroxystyrol, p-Aminostyrol oder Copolymeren dieser beiden Verbindungen. Besonders brauchbare Sensibi-lisatoren sind die 1,2-Chinondiazidsulfonsäure-4-ester.

Als Ester der 1,2-Chinondiazidderivate kommen die bekannten Umsetzungsprodukte der Säuren oder ihrer Halogenide mit Phenolen, insbesondere mehrwertigen Phenolen in Betracht, zum Beispiel mit 2,3,4-Trihydroxy-benzophenon, 2,4-Dihydroxybenzophenon, 4-Decanoyl-resorcin, 4-(2-Phenylprop-2-yl)phenol, Gallussäureoctylester oder 4,4-Bis-(4-hydroxyphenyl)valeriansäurebutylester. Besonders vorteilhaft gemäß der Erfindung hat sich das Veresterungsprodukt aus 1 Mol 4-(2-Phenylprop-2-yl)-phenol und 1 Mol Naphthochinon-(1,2)-diazid-(2)-4-sulfonsäurechlorid erwiesen.

Die Menge an o-Chinondiazidverbindungen beträgt im allgemeinen 3 bis 50, bevorzugt 7 bis 35 Gewichtsprozent, bezogen auf die nichtflüchtigen Anteile der Kopierschicht.

Als lichtempfindliche Komponenten, die beim Belichten starke Säuren bilden, sind eine große Anzahl von bekann ten Verbindungen und Mischungen, wie Phosphonium-, Sulfonium-und Jodoniumsalze, Halogenverbindungen und Organometall-Organohalogen-Kombinationen geeignet.

Die genannten Phosphonium-, Sulfonium-und

Jodoniumverbindungen werden in der Regel eingesetzt in Form ihrer in organischen Lösungsmitteln löslichen Salze, meist als Abscheidungsprodukt mit komplexen Säuren wie Borfluorwasserstoffsäure, Hexafluorphospor-, Hexafluorantimon-und -arsensäure.

Grundsätzlich sind als halogenhaltige lichtempfindliche und Halogenwasserstoffsäure bildende Verbindungen alle auch als photochemische Radikalstarter bekannten organischen Halogenverbindungen, beispielsweise solche mit mehr als einem Halogenatom an einem Kohlenstoffatom oder an einem aromatischen Ring, brauchbar. Beispiele sind in den US-A 3 515 552, 3 536 489 und 3 779 778, der DE-C 26 10 842 und den DE-A 22 43 621, 27 18 259 und 33 37 024 beschrieben. Von diesen Verbindungen werden die s-Triazinderivate mit 2 Halogenmethylgruppen, insbesondere Trichlormethylgruppen und einem aromatischen bzw. ungesättigten Substituenten im Triazinkern, wie sie in den DE-A 27 18 259 und 33 37 024 beschrieben sind, bevorzugt. Ebenso gut geeignet sind die in den DE-A 28 51 471 und 29 49 396 beschriebenen 2-Trichlormethyl-1,3,4-oxdiazole. Die Wirkung dieser halogenhaltigen Verbindungen kann auch durch bekannte Sensibilisatoren spektral beeinflußt und gesteigert werden.

Beispiele für geeignete Starter sind:

4-Methyl-6-trichlormethyl-2-pyron, 4-(3,4,5-Trimethoxystyryl)-6-trichlormethyl-2-pyron, 4-(4-Methoxystyryl)-6-(3,3,3-trichlorpropenyl)-2-pyron, 2-Trichlormethylbenzimidazol, 2-Tribrommethylchinolin, 2,4-Dimethyl-1-tribromacetyl-benzol, 3-Nitro-1-tribromacetyl-benzol, 4-Dibromacetyl-benzoesäure, 1,4-Bis-dibrommethylbenzol, Tris-dibrommethyl-s-triazin, 2-(6-Methoxy-naphth-2-yl)-, 2-(Naphth-1-yl)-, 2-(Naphth-2-yl)-, 2-(4-Ethoxy-ethyl-naphth-1-yl)-, 2-(Benzopyran-3-yl)-, 2-(4-Methoxyanthrac-1-yl)-, 2-(4-Styryl-phenyl)-, 2-(Phenanthr-9-yl)-4,6-bis-trichlormethyl-s-triazin und die in den Beispielen aufgeführten Verbindungen.

Die Menge des Starters kann je nach seiner chemischen Natur und der Zusammensetzung der Schicht ebenfalls sehr verschieden sein. Günstige Ergebnisse werden erhalten mit etwa 0,5 bis 20 Gewichtsprozent, bezogen auf den Gesamtfeststoff, bevorzugt sind 1,0 bis 12 Gewichtsprozent. Besonders für lichtempfindliche Schichten von Dicken über 0,01 mm empfiehlt es sich, relativ wenig Säurespender zu verwenden.

Als durch Säure spaltbare Verbindungen sind in erster Linie zu nennen:

A) solche mit mindestens einer Orthocarbonsäureester-und bzw. oder Carbonsäureamidacetalgruppierung, wobei die Verbindungen auch polymeren Charakter haben und die genannten Gruppierungen als verknüpfende Elemente in der Hauptkette oder als seitenständige Substituenten auftreten können.

B) Oligomer-oder Polymerverbindungen mit wiederkehrenden Acetal-und/oder Ketalgruppierungen in der Hauptkette und

C) Verbindungen mit mindestens einer Enolether-oder N-Acyliminocarbonatgruppierung.

Durch Säure spaltbare Verbindungen des Typs (A) als Komponenten lichtempfindlicher Gemische sind in der US-A 4 101 323 und in der EP-A 0 022 571 ausführlich beschrieben; Gemische, die Verbindungen des Typs (B) enthalten, sind in den DE-C 23 06 248 und 27 18 254 sowie in der US-A 3 779 778 beschrieben; Verbindungen des Typs (C) werden in den EP-A 0 006 626 und 0 006 627 beschrieben.

Der Anteil der spaltbaren Verbindung kann variiert werden zwischen 4 und 50, bevorzugt werden 5 bis 30 Gewichts-prozent.

Die lichtempfindlichen Gemische enthalten ferner vorzugsweise ein polymeres, wasserunlösliches harzartiges Bindemittel, das sich in den für das Gemisch verwendeten Lösungsmitteln löst und in wäßrigen Alkalien ebenfalls löslich oder zumindest quellbar ist.

Die bei vielen Positiv-Kopiermaterialien auf Basis von Naphthochinondiaziden bewährten Novolak-Kondensationsharze haben sich als Bindemittel auch bei dem erfindungsgemäßen Verfahren als vorteilhaft erwiesen. Die Novolake können auch in bekannter Weise durch Umsetzung eines Teils ihrer Hydroxygruppen, zum Beispiel mit Chloressigsäure, Isocyanaten, Epoxiden oder Carbonsäureanhydriden, modifiziert sein. Als weitere alkalilösliche bzw. in Alkali quellbare Bindemittel werden Polyhydroxyphenolharze, die durch Kondensation aus Phenolen und Aldehyden oder Ketonen hergestellt werden, Mischpolymerisate aus Styrol und Maleinsäureanhydrid, Polyvinylphenole oder Mischpolymerisate der Acrylsäure oder Methacrylsäure, insbesondere mit Acryl-oder Methacrylsäurephenolestern, bevorzugt. Die Art und Menge der Bindemittel kann je nach Anwendungszweck verschieden sein; bevorzugt werden Anteile am Gesamtfeststoff zwischen 90 und 30, besonders bevorzugt 85 - 55 Gewichtsprozent.

Zusätzlich können noch zahlreiche andere Harze mitverwendet werden, bevorzugt Epoxyharze und Vinylpolymerisate wie Polyvinylacetate, Polyacrylate, Polyvinylacetale, Polyvinylether, Polyvinylpyrrolidone und die Mischpolymerisate der ihnen zugrundeliegenden Monomeren sowie hydrierte oder teilhydrierte Kolophoniumderivate. Der günstigste Anteil an diesen Harzen richtet sich nach den anwendungstechnischen Erfordernissen und nach dem Einfluß auf die Entwicklungsbedingungen, er beträgt im allgemeinen nicht mehr als

50, bevorzugt etwa 2 bis 35 Gewichtsprozent vom Bindemittel. In geringen Mengen kann das lichtempfindliche Gemisch für spezielle Erfordernisse wie Flexibilität, Haftung, Glanz und Färbung, außerdem noch Substanzen wie Polyglykole, Cellulose-Derivate wie Ethylcellulose, Netzmittel, Farbstoffe, Haftvermittler und feinteilige Pigmente sowie bei Bedarf UV-Absorber enthalten.

Ferner können dem lichtempfindlichen Gemisch für den Farb-umschlag nach dem Belichten noch geringe Mengen von strahlungsempfindlichen Komponenten beigefügt werden, die beim Belichten vorzugsweise starke Säuren bilden bzw. abspalten und in einer Folgereaktion mit einem geeigneten Farbstoff einen Farbumschlag hervorrufen. Derartige strahlungsempfindliche Komponenten sind zum Beispiel 1,2-Naphthochinondiazid-4-sulfonsäurechlorid, chromophor substituierte Bis-oder Trishalogenmethyl-s-triazine, Diazoniumverbindungen in Form ihrer Salze mit komplexen Säuren wie Borfluorwasserstoffsäure oder Hexafluorphosphorsäure oder 4-Dialkoxyaminoazobenzole.

Besonders bevorzugte lichtempfindliche Gemische enthalten 2-Dialkylamino-4,6-dialkoxy-s-triazin, Naphthochinon-(1,2)-diazid-(2)-4-sulfonsäureester, 4-Dialkylaminoazobenzol oder 2,4-Bistrihalogenmethyl-s-triazin und Triphenylme-thanfarbstoff.

Gegenstand der Erfindung ist ferner ein lichtempfindliches Kopiermaterial, bestehend aus einem Schichtträger und einer lichtempfindlichen Schicht, die im wesentlichen ein wasser unlösliches, in wäßrig-alkalischen Lösungen lösliches Bindemittel, ein lichtempfindliches 1,2-Chinondiazid oder ein lichtempfindliches Gemisch aus einer bei Belichtung Säure abspaltenden Verbindung und einer Verbindung mit mindestens einer durch Säure spaltbaren C-O-C-Gruppe und eine thermische Härtung fördernde Substanz enthält. Das Kopiermaterial ist dadurch gekennzeichnet, daß es als thermische Härtung fördernde Substanz mindestens eine Verbindung nach Ansprüchen 1 bis 3 enthält.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemäße Gemisch sind Ketone, wie Methylethylketon, chlorierte Kohlenwasserstoffe wie Trichlorethylen und 1,1,1-Trichlorethan, Alkohole wie n-Propanol, Ether wie Tetrahydrofuran, Alkoholether wie Ethylenglykol-monoethylether und Ester wie Butylacetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den Schichtkomponenten nicht irreversibel reagieren. Partialether von Glykolen, insbesondere Ethylenglykolmonomethylether und Propylenglykolmethylether werden besonders bevorzugt.

Als Schichtträger für Schichtdicken unter ca. 10 m werden meist Metalle verwendet. Für Offsetdruckplatten kön nen nen eingesetzt werden: Walzblankes, mechanisch oder elektrochemisch aufgerauhtes und gegebenenfalls anodisiertes Aluminium, das zudem noch chemisch, z.B. mit Polyvinylphosphonsäure, Silikaten, Phosphaten, Hexafluorozirkonaten oder mit hydrolisiertem Tetraethylorthosilikat, vorbehandelt sein kann.

Die Beschichtung des Schichtträgers erfolgt in bekannter Weise durch Aufschleudern, Sprühen, Tauchen, Walzen mittels Breitschlitzdüsen, Rakeln oder durch Gießer-Antrag.

Belichtet wird mit den in der Technik üblichen Lichtquellen.

Die Erfindung betrifft ferner Verfahren zur Herstellung negativer Reliefkopien, bei denen ein lichtempfindliches Kopiermaterialaus einem Schichtträger mit einer lichtempfindlichen Schicht, die im wesentlichen ein wasserunlösliches, in wäßrig-alkalischen Lösungen lösliches Bindemittel, ein lichtempfindliches 1,2-Chinondiazid oder ein lichtempfindliches Gemisch aus einer bei Belichtung Säure abspaltenden Verbindungund einer Verbindung mit mindestens einer durch Säure spaltbaren C-O-C -Gruppe und eine thermische Härtung fördernde Substanz enthält, bildmäßig belichtet, danach erwärmt, nach dem Abkühlen vollflächig belichtet und dann mittels eines wäßrig-alkalischen Entwicklers entwikkelt wird. Das Verfahren ist dadurch gekennzeichnet, daß man als die thermische Härtung fördernde Substanz mindestens eine Verbindung nach Ansprüchen 1 bis 3 verwendet.

In Abänderung des Verfahrens ist es auch zur Herstellung von Reliefkopien, die sowohl negative als auch positive Bilder wiedergeben geeignet. Hierzu wird das Kopiermaterial unter einer Negativ-Vorlage bildmäßig belichtet und danach erwärmt und dann nach dem Abkühlen unter einer Positiv-Vorlage in den noch nicht bildmäßig belichteten Bereichen belichtet und anschließend mittels eines wäßrigalkalischen Entwicklers entwickelt.

Zur Umkehrbehandlung wird das Kopiermaterial nach dem bildmäßigen Bestrahlen bzw. Belichten unter einer Negativ-Vorlage ohne weitere Zwischenbehandlung erwärmt. Das Erwärmen kann durch Bestrahlung, Konvektion, durch Kontakt mit erwärmten Flächen, zum Beispiel Walzen, oder Tauchen in ein erwärmtes Bad einer inerten Flüssigkeit, zum Beispiel Wasser, erfolgen. Die Erwärmungstemperatur liegt zwischen 80 und 150, insbesondere zwischen 100 bis 130 °C. Derartige

Temperaturen werden von den Gemischen vertragen, ohne daß die Eigenschaften der unbelichteten Bereiche wesentlich verändert werden. Die Dauer des Erwärmens des Kopiermaterials kann je nach Art der Wärme-einwirkung sehr unterschiedlich sein. Bei Übertragung durch ein Wärmemedium liegt sie zwischen 10 Sekunden und 10 Minuten, besonders zwischen 1 und 3 Minuten.

Nach dem Erwärmen und Abkühlen wird die Druckplatte einer Totalbelichtung unterworfen, um die noch lichtempfindlichen Schichtbereiche vollständig in ihre Lichtzersetzungsprodukte umzuwandeln. Die Nachbelichtung kann vor teilhaft unter der gleichen Lichtquelle erfolgen, die zur Bildbelichtung verwendet wurde.

An die Nachbelichtung schließt sich eine Entwicklung mit üblichen Entwicklern an, wobei die Schichtbereiche ausgewaschen werden, die bei der ursprünglichen Bildbelichtung nicht vom Licht getroffen waren. Als Entwickler sind vorzugsweise wäßrige Lösungen von alkalischen Substanzen abgestufter Alkalität, zum Beispiel von Alkaliphosphaten, -silikaten, -carbonaten oder -hydroxiden geeignet. Der pH-Bereich liegt im allgemeinen zwischen 10 und 14. Der Entwickler enthält ferner Netzmittel oder kleinere Mengen organischer Lösungsmittel. In bestimmten Fällen sind auch organische Lösungsmittel oder Gemische derselben mit Wasser als Entwickler geeignet. Die Entwicklung kann unmittelbar nach dem Erwärmen und Abkühlen oder auch in zeitlichem Abstand von z.B. mehreren Stunden erfolgen, ohne daß die gehärteten Schichtbereiche angegriffen werden.

Zwecks Erhöhung der Druckauflage kann eine übliche thermische Nachhärtung erfolgen.

Das erfindungsgemäße Kopiermaterial besitzt eine gute Lagerfähigkeit, auch bei erhöhter Temperatur. Die Aushärtung der bildmäßig belichteten Schichtbereiche in der Wärme erfolgt relativ - schnell, die Temperatur des für den Umkehrschritt erforderlichen Erwärmens ist niedriger und die Verweilzeit bei erhöhter Temperatur wesentlich kürzer als bei den bekannten Materialien.

Das Verfahren hat ferner den Vorteil, daß in Gegenwart der erfindungsgemäß verwendeten symmetrischen Triazine in der Kopierschicht die Temperaturtoleranzendes Umkehrspielraums relativ groß sind, wodurch die Tonwertwiedergabe auch bei großen Temperaturschwankungen während des Umkehrschrittes nicht nachteilig beeinflußt wird.

Wie schon erwähnt lassen sich mit den erfindungsgemäßen Kopiermaterialien außer der Herstellung einer Negativ-Kopie von der normalerweise positiv-arbeitenden Kopierschicht auch vorteilhaft verschiedene Kombinationsmöglichkeiten beim Zusammenkopieren von Strich-und Rasterfilmen verwirklichen (Photocomposing). So kann man beispielsweise unmittelbar nach der ersten bildmäßigen Belichtung unter einer Negativ-Vorlage nachträglich an den noch nicht vom Licht getroffenen Schichtbereichen, die während der ersten Belichtung durch eine Maske abgedeckt waren, mit Hilfe einer Positiv-Vorlage zusätzlich noch ein weiteres Strich-oder Rasterbild einkopieren. Die so belichtete Druckplatte wird anschließend ohne weitere Zwischenschritte entwickelt. Man erhält auf diese Weise die fertige Druckform.

Zusätzliche Behandlungsschritte mit Flüssigkeiten oder eine besondere Zusammensetzung des lichtempfindlichen Materials sind nicht erforderlich. Der einzige zusätzliche Behandlungsschritt, das Erwärmen, kann zumeist mit vorhandenen Trocknungsgeräten bequem durchgeführt werden. Die Nachbelichtung ohne Vorlage wird am einfachsten wieder mit der Kopierlichtquelle durchgeführt.

Das erfindungsgemäße Verfahren kann zum Beispiel zur Her-stellung von Druckformen für den Hoch-, Tief-und Flach druck sowie von Photoresistschablonen für die substraktive und additive Leiternplattenherstellung, für die galvanische Herstellung von Nickelrotationszylindern oder für die Maskenherstellung in der Mikroelektronik nach der Lift-off-Technik eingesetzt werden.

Die folgenden Beispiele beschreiben bevorzugte Ausführungsformen des erfindungsgemäßen Verfahrens. Prozentzahlen und Mengenverhältnisse sind, wenn nichts anderes angegeben ist, in Gewichtseinheiten zu verstehen.

Beispiel 1:

Mit einer Lösung von

1,700 Gt des Veresterungsproduktes aus 1 Mol 4-(2-Phenyl-prop-2-yl)-phenol und 1 Mol Naphthochinon-(1,2)-diazid-(2)-4-sulfonsäurechlorid,
0,600 Gt 2-Diethylamino-4,6-diethoxy-s-triazin,
8,500 Gt eines Kresol-Formaldehyd-Novolaks mit einem Erweichungspunkt von 127 - 145 °C,
0,400 Gt 2,4-Dihydroxybenzophenon
0,060 Gt 2,4-Bis-trichlormethyl-6-p-stilbenyl-s-triazin
0,070 Gt Kristallviolett, Color Index (C.I.) 42 555, in
70,00 Gt Ethylenglykolmonomethylether und
70,00 Gt Tetrahydrofuran

wurde eine elektrolytisch aufgerauhte und anodisierte Aluminiumplatte beschichtet. Der anodisierte Aluminiumträger war vor dem Aufbringen der lichtempfindlichen Kopierschicht mit einer wäßrigen Lösung von Polyvinylphosphonsäure behandelt worden, wie es in der DE-PS 16 21 468 entsprechend US-PS 4,153,461 beschrieben ist.

Das so hergestellte vorsensibilisierte Kopiermaterial mit einem Trockenschichtgewicht von ca. 2,3 $g/m^2$ wurde unter einer transparenten Positiv-Vorlage bildmäßig belichtet und anschließend mit der 4 %igen wäßrigen Lösung von Natriumsilikat entwickelt. Durch die Entwicklung wurden die vom Licht getroffenen Anteile der Kopierschicht entfernt, und es blieben die unbelichteten Bildstellen auf dem Schichtträger zurück, wodurch man die der Vorlage entsprechende Druckschablone erhielt. Durch Einfärben mit Fettfarbe wurde eine druckfertige Positiv-Druckform erhalten.

Eine andere Probe des gleichen vorsensibilisierten Kopiermaterials wurde als Negativ-Druckplatte verarbeitet. Zu diesem Zweck wurde die Probe unter einer negativen Vorlage belichtet, anschließend 2 Minuten auf 120 °C erwärmt und dann ohne Vorlage dieselbe Zeit wie bei der bildmäßigen Belichtung nachbelichtet. Beim Entwickeln im gleichen Entwickler innerhalb der gleichen Zeit entstand das Umkehrbild der Vorlage.

Eine andere Möglichkeit der Verarbeitung ist das nachträgliche Einkopieren von Strich-oder Rastervorlagen auf eine bereits bildmäßig belichtete Druckplatte nach dem Photo composing-Verfahren. Zu diesem Zweck wird die Druckplatte zunächst unter einer Negativ-Vorlage, wie oben angegeben, bildmäßig belichtet, anschließend 2 Minuten auf 120 °C erwärmt, dann an den noch nicht vom Licht getroffenen Schichtbereichen unter einem Diapositiv nochmals belichtet. Die so mehrmals belichtete Druckplatte wird ohne weitere Zwischenschritte entwickelt, wodurch die fertige Druckplatte erhalten wird.

Ein großer Vorteil gegenüber den bisher bekannten Umkehrplatten und Verfahren ist der relativ große Behandlungsspielraum während des Erwärmungungsschrittes. Dies wird deutlich, wenn die hergestellte normalerweise positiv arbeitende lichtempfindliche Druckplatte unter einer Negativ-Vorlage in Gegenwart eines in der Offsetkopie üblichen Testkeils, beispielsweise des UGRA-Offset-Testkeils 1982, bildmäßig belichtet und anschließend der zur Bildumkehr notwendige Erwärmungsschritt durchgeführt wird.

Wird das Erwärmen der bildmäßig belichteten Druckplatte beispielsweise während 2 Minuten durchgeführt, so kann die Temperatur zwischen 80 und 150 °C variiert werden, ohne daß an dem resultierenden Testbild nach der anschließenden vollflächigen Nachbelichtung und Entwicklung eine wesentliche Veränderung sichtbar wird. Diese große Temperaturtoleranz des eigentlichen Umkehrschrittes während der Verarbeitung kommt der Praxis sehr entgegen, da die kopiertechnischen Eigenschaften, wie beispielsweise die Tonwiedergabe, auch bei relativ großen Temperaturschwankungen, wie sie bei den in der Praxis üblichen Wärmeöfen oder automatischen Conversionsgeräten durchaus vorkommen können, nicht nachteiligbeeinflußt werden.

Wird das erfindungsgemäß verwendete 2-Diethylamino-4,6-diethoxy-s-triazin beispielsweise durch die gleiche Menge eines Hexamethylolmelaminhexamethylethers gemäß EP-A-0 133 216 ersetzt und nach dem bildmäßigen Belichten unter derselben Testvorlage ebenfalls während zwei Minuten der Temperungsschritt durchgeführt, so resultiert lediglich ein Temperaturspielraum von etwa 20 °C.

Die ausgezeichnete Lagerfähigkeit des erfindungsgemäßen Kopiermaterials wird deutlich, wenn die hergestellte Druckplatte einem Lagertest bei 100 °C ausgesetzt wird. Noch nach einer Lagerzeit von 4 Stunden bei 100 °C läßt sich die hergestellte erfindungsgemäße Druckplatte nach der bildmäßigen Belichtung einwandfrei entwickeln, während eine entsprechende Druckplatte, die Hexamethylolmelaminhexamethylether enthält, bereits schon nach 45 Sekunden Lagerung bei 100 °C nach dem anschließenden bildmäßigen Belichten sich nicht mehr einwandfrei entwickeln läßt.

In den folgenden Beispielen werden weitere Beschichtungslösungen angegeben, wobei ähnliche Ergebnisse erhalten werden, wie in Beispiel 1 angegeben. Wenn nicht gesondert vermerkt, entsprechen Herstellung und Verarbeitung der damit erhaltenen Druckplatten den in Beispiel 1 beschriebenen Bedingungen. Die Entwicklung der belichteteten Druckplatten erfolgt jeweils mit einer 4 oder 5 %igen wässrigen Natriummetasilikatlösung.

Beispiel 2

Die Beschichtungslösung besteht aus:

1,600 Gt des Veresterungsproduktes aus 1 Mol 4-(2-Phenyl-prop-2-yl)-phenol und 1 Mol Naphthochinon-(1,2)-diazid-(2)-4-sulfonsäurechlorid,
0,900 Gt 2,6-Bis-(diethylamino)-4-methoxy-s-triazin,
8,600 Gt eines Kresol-Formaldehyd-Novolaks mit einem Erweichungspunkt von 127 - 145 °C,
0,080 Gt 2,4-Bis-trichlormethyl-6-p-stilbenyl-s-triazin
0,400 Gt 2,3,4-Trihydroxybenzophenon,
0,070 Gt Kristallviolett in
60,00 Gt Propylenglykolmonomethylether und
80,00 Gt Tetrahydrofuran

Beispiel 3

Die Beschichtungslösung besteht aus:

1,700 Gt des Veresterungsproduktes aus 1 Mol 4-(2-Phenyl-prop-2-yl)-2,6-dibromphenol und 1 Mol Naphthochinon-(1,2)-diazid-(2)-4-sulfonsäurechlorid,
0,700 Gt 2-Diethylamino-4,6-diphenoxy-s-triazin,
9,00 Gt eines Kresol-Formaldehyd-Novolaks mit einem Erweichungspunkt von 127 - 145 °C,
0,050 Gt 2,4-Bis-trichlormethyl-6-p-methoxystyryl-s-triazin,
0,070 Gt Kristallviolett in
70,00 Gt Propylenglykolmonomethylether und
70,00 Gt Tetrahydrofuran

Beispiel 4

Die Beschichtungslösung besteht aus:

1,600 Gt des Veresterungsproduktes aus 1 Mol 2,2′-Dihydroxydinaphthyl-(1,1′)-methan und 2 Mol Naphthochinon-(1,2)-diazid-(2)-4-sulfonsäurechlorid,
0,700 Gt 2-(Methylcyclohexyl)-amino-4,6-dimethoxy-s-triazin,
8,600 Gt eines Kresol-Formaldehyd-Novolaks mit einem Erweichungspunkt von 127 - 145 °C,
0,060 Gt 2,4-Bis-trichlormethyl-6-p-stilbenyl-s-triazin
0,400 Gt 2,4-Dihydroxybenzophenon,
0,070 Gt Kristallviolett in
60,00 Gt Ethylenglykolmonomethylether und
80,00 Gt Tetrahydrofuran

Beispiel 5

Die Beschichtungslösung besteht aus:

1,600 Gt des Veresterungsproduktes aus 1 Mol 4-(2-Phenyl-prop-2-yl)-2,6-dibromphenol und 1 Mol Naphthochinon-(1,2)-diazid-(2)-4-sulfonsäurechlorid,
1,200 Gt 2,4,6-Trimethoxy-s-triazin,
8,400 Gt eines Kresol-Formaldehyd-Novolaks mit einem Erweichungspunkt von 127 - 145 °C,
0,080 Gt 2,4-Bis-trichlormethyl-6-p-methoxystyryl-s-triazin,
0,300 Gt 2,4-Dihydroxybenzophenon,
0,070 Gt Kristallviolett in
60,00 Gt Ethylenglykolmonomethylether und
80,00 Gt Tetrahydrofuran

Beispiel 6

Die Beschichtungslösung besteht aus:

1,700 Gt des Veresterungsproduktes aus 1 Mol 2,3,4-Trihydroxybenzophenon und 3 Mol Naphthochinon-(1,2)-diazid-(2)-4-sulfonsäurechlorid,
0,800 Gt 2-Diethylamino-4,6-diethoxy-s-triazin,
8,600 Gt eines Kresol-Formaldehyd-Novolaks mit einem Erweichungspunkt von 127 - 145 °C,
0,080 Gt 2,4-Bis-trichlormethyl-6-p-methoxystyryl-s-triazin,
0,070 Gt Kristallviolett in
70,00 Gt Propylenglykolmonomethylether und
70,00 Gt Tetrahydrofuran

Beispiel 7

Die Beschichtungslösung besteht aus:

1,600 Gt des Veresterungsproduktes aus 1 Mol 2,2-Bis-(4-hydroxyphenyl)-propan und 2 Mol Naphthochinon-(1,2)-diazid-(2)-4-sulfonsäurechlorid,
1,00 Gt 2,4,6-Triphenoxy-s-triazin,
8,400 Gt eines Kresol-Formaldehyd-Novolaks mit einem Erweichungspunkt von 127 - 145 °C,
0,080 Gt 2,4-Bis-trichlormethyl-6-p-methoxystyryl-s-triazin,
0,070 Gt Kristallviolett in
50,00 Gt N,N-Dimethylformamid und
90,00 Gt Ethylenglykolmonomethylether

Beispiel 8

Mit einer Lösung von

1,400 Gt eines Polyorthoesters, hergestellt aus 7,7-Bishydroxymethyl-5-oxa-nonanol-(1) und Orthoameisensäuretrimethylester,
0,220 Gt 2,4-Bis-(trichlormethyl)-6-p-stilbenyl-s-triazin,
0,140 Gt 2-Diethylamino-4,6-diethoxy-s-triazin,
4,700 Gt des in Beispiel 1 angegebenen Novolaks,
0,040 Gt Kristallviolett-Base in
35,00 Gt Propylenglykolmonomethylether und
45,00 Gt Tetrahydrofuran

wurde eine elektrolytisch aufgerauhte und anodisierte Aluminiumplatte beschichtet.

Das so hergestellte vorsensibilisierte Kopiermaterial mit einem Trockenschichtgewicht von ca. 2,0 g/m² wurde unter einer transparenten Positiv-Vorlage mit Hilfe einer Metall-Halogenid-Lampe von 500

Watt bei einem Lampenabstand von 103 cm mit 10 Takten bildmäßig belichtet und anschließend mit einer 4 %igen wäßrigen Lösung von Natriumsilikat entwickelt. Durch die Entwicklung wurden die vom Licht getroffenen Anteile der Kopierschicht entfernt, und es blieben die unbelichteten Bildstellen auf dem Schichtträger zurück, wodurch man die der Vorlage entsprechende Druckschablone erhielt. Durch Einfärben mit Fettfarbe wurde eine druckfertige Positiv-Druckform erhalten.

Eine andere Probe des gleichen vorsensibilisierten Materials wurde als Negativ-Druckplatte verarbeitet. Zu diesem Zweck wurde die Probe unter einer negativen Vorlage 10 Takte lang belichtet, anschließend 2 Minuten auf 130 °C erwärmt und dann ohne Vorlage 10 Takte nachbelichtet. Durch Entwickeln im gleichen Entwickler innerhalb der gleichen Zeit entstand das Umkehrbild der Vorlage.

Beispiel 9

Mit einer Lösung von

1,800 Gt des Veresterungsproduktes aus 1 Mol 4-(2-Phenyl-prop-2-yl)-phenol und 1 Mol Naphthochinon-(1,2)-diazid-(2)-4-sulfonsäurechlorid,
0,850 Gt 2-Diethylamino-4,6-diethoxy-s-triazin,
7,000 Gt eines Kresol-Formaldehyd-Novolaks mit einem Erweichungspunkt von 127 - 145 °C,
1,000 Gt eines Kresol-Formaldehyd-Novolaks mit einem Erweichungspunkt von 115 - 125 °C,
0,400 Gt Bis-(4-hydroxyphenyl)-sulfon
0,040 Gt Diethylamino-azobenzol (Sudangelb GGN, Color Index Nr. 11021),
0,140 Gt Viktoriareinblau FBO in
70,00 Gt Ethylenglykolmonomethylether und
70,00 Gt Tetrahydrofuran

wurde eine elektrolytisch aufgerauhte und anodisierte Aluminiumplatte beschichtet. Der anodisierte Aluminum träger war vor dem Aufbringen der lichtempfindlichen Kopierschicht mit einer wäßrigen Lösung von Polyvinylphosphonsäure behandelt worden, wie es in der DE-C 16 21 468 entsprechend US-A 4,153,461 beschrieben ist.

Das so hergestellte vorsensibilisierte Kopiermaterial mit einem Trockenschichtgewicht von ca. 2,3 g/m² wurde unter einer transparenten Positiv-Vorlage bildmäßig belichtet und anschließend mit einer 4 %igen wäßrigen Lösung von Natriumsilikat entwickelt. Durch die Entwicklung wurden die vom Licht getroffenen Anteile der Kopierschicht entfernt, und es blieben die unbelichteten Bildstellen auf dem Schichtträger zurück, wodurch man die der Vorlage entsprechende Druckschablone erhielt. Durch Einfärben mit Fettfarbe wurde eine druckfertige Positiv-Druckform erhalten.

Eine andere Probe des gleichen vorsensibilisierten Kopiermaterials wurde als Negativ-Druckplatte verarbeitet. Zu diesem Zweck wurde die Probe unter einer negativen Vorlage in Gegenwart eines Halbtonstufenkeils belichtet, anschließend 2 Minuten auf 120 °C erwärmt und dann ohne Vorlage dieselbe Zeit wie bei der bildmäßigen Belichtung nachbelichtet. Beim Entwickeln im gleichen Entwickler innerhalb der gleichen Zeit entstand das Umkehrbild der Vorlage.

Der resultierende relativ große Umkehrspielraum, d.h. der Bereich zwischen der unteren Temperatur, bei der die getemperten Schichtbereiche gerade resistent gegenüber dem Entwickler geworden sind, und der oberen Temperatur, bei der sich nachteilige kopiertechnische Eigenschaften abzuzeichnen beginnen, kann dadurch dokumentiert werden, daß man die Temperatur des Erwärmungsschrittes der bildmäßig belichteten Druckplatte zwischen 80 und 150 °C während 2 Minuten variiert. Hierbei ist nach der anschließenden vollflächigen Nachbelichtung und Entwicklung keine wesentliche Änderung an dem Testbild, insbesondere an einem mitkopierten Halbtonstufenkeil, erkennbar. Diese große Temperaturtoleranz des Umkehrschrittes ist für die Verarbeitung in der Praxis von großem Vorteil.

Das gleiche Ergebnis wird mit der nach Beispiel 10 hergestellten Druckplatte bei entsprechender Verarbeitung erhalten.

Beispiel 10

1,800 Gt des Veresterungsproduktes aus 1 Mol 4-(2-Phenyl-prop-2-yl)-phenol und 1 Mol Naphthochinon-(1,2)-diazid-(2)-4-sulfonsäurechlorid,
0,850 Gt 2-Diethylamino-4,6-diethoxy-s-triazin,
6,000 Gt eines Copolymerisates aus Styrol und Brenzcatechinmethacrylsäureester im Molverhältnis 30 : 70,
1,500 Gt eines Kresol-Formaldehyd-Novolaks mit einem Erweichungspunkt von 115 - 125 °C,
0,700 Gt Bis-(4-hydroxyphenyl)-sulfon
0,040 Gt Diethylamino-azobenzol,
0,150 Gt Viktoriareinblau FBO in
70,00 Gt Ethylenglykolmonomethylether und
70,00 Gt Tetrahydrofuran

## Ansprüche

1. Lichtempfindliches Gemisch, das im wesentlichen ein wasserunlösliches, in wäßrig-alkalischen Lösungen lösliches Bindemittel, ein lichtempfindliches 1,2-Chinondiazid oder ein lichtempfindliches Gemisch aus einer bei Belichtung Säure abspaltenden Verbindung und einer Verbindung mit mindestens einer durch Säure spaltbaren C-O-C -Gruppe und eine thermische Härtung fördernde Substanz enthält, dadurch gekennzeichnet, daß als thermische Härtung fördernde Substanz eine Verbindung der allgemeinen Formel I

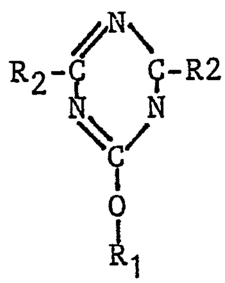

worin $R_1$ Alkyl oder Aryl und
$R_2$ Alkoxy, Aryloxy oder eine durch Alkyl, Cycloalkyl oder Aryl mono-oder disubstituierte Aminogruppe sein können,

vorhanden ist.

2. Gemisch nach Anspruch 1, dadurch gekennzeichnet, daß als thermische Härtung fördernde Substanz eine Verbindung der allgemeinen Formel I vorhanden ist,

worin $R_1$ $(C_1-C_4)$-Alkyl oder Phenyl und
$R_2$ $(C_1-C_4)$-Alkoxy, Phenoxy oder eine durch $(C_1-C_4)$-Alkyl, $(C_4-C_8)$-Cycloalkyl mono-oder disubstituierte Aminogruppe sein können.

3.Gemisch nach Anspruch 1 oder 2, dadurch gekennzeichnet, daß als thermische Härtung fördernde Substanz 2-Dialkylamino-4,6-dialkoxy-s-triazin vorhanden ist.

4. Gemisch nach Ansprüchen 1 bis 3, enthaltend 2-Dialkylamino-4,6-dialkoxy-s-triazin, Naphthochinon-(1,2)-diazid-(2)-4-sulfonsäureester, 4-Dialkylaminoazobenzol und Triphenylmethanfarbstoff.

5. Gemisch nach Ansprüchen 1 bis 3, enthaltend 2-Dialkylamino-4,6-dialkoxy-s-triazin, Naphthochinon-(1,2)-diazid-(2)-4-sulfonsäureester, 2,4-Bis-trihalogenmethyl-s-triazin und Triphenylmethanfarbstoff.

6. Lichtempfindliches Kopiermaterial, bestehend aus einem Schichtträger und einer lichtempfindlichen Schicht, die im wesentlichen ein wasserunlösliches, in wäßrig-alkalischen Lösungen lösliches Bindemittel, ein lichtempfindliches 1,2-Chinondiazid oder ein lichtempfindliches Gemisch aus einer bei Belichtung Säure abspaltenden Verbindung und einer Verbindung mit mindestens einer durch Säure spaltbaren C-O-C -Gruppe und eine die thermische Härtung fördernde Substanz enthält, dadurch gekennzeichnet, daß als thermische Härtung fördernde Substanz midestens eine Vernbindung nach Ansprüchen 1 bis 5 vorhanden ist.

7. Verfahren zur Herstellung von negativen Reliefkopien, bei dem ein lichtempfindliches Kopiermaterialaus einem Schichtträger mit einer lichtempfindlichen Schicht, die im wesentlichen ein wasserunlösliches, in wäßrig-alkalischen Lösungen lösliches Bindemittel, ein lichtempfindliches 1,2-Chinondiazid oder ein lichtempfindliches Gemisch aus einer bei Belichtung Säure abspaltenden Verbindung und einer Verbindung mit mindestens einer durch Säure spaltbaren C-O-C -Gruppe und eine thermische Härtung fördernde Substanz enthält, bildmäßig belichtet, danach erwärmt, nach dem Abkühlen vollflächig belichtet und dann mittels eines wäßrig-alkalischen Entwicklers entwickelt wird, dadurch gekennzeichnet, daß man als thermische Härtung fördernde Substanz mindestens eine Verbindung nach Ansprüchen 1 bis 5 verwendet.

8. Verfahren nach Anspruch 7, dadurch gekennzeichnet, daß man das bildmäßig belichtete Material auf eine Temperatur im Bereich von 80 - 150 °C erwärmt.

9. Verfahren nach Anspruch 7 und 8, dadurch gekennzeichnet, daß man das bildmäßig belichtete Material 10 Sekunden bis 10 Minuten erwärmt.

10. Abänderung des Verfahrens nach Ansprüchen 7 bis 9, dadurch gekennzeichnet, daß man das Material zum Zusammenkopieren von Negativ-und Positivkopien nach dem Ab kühlen mit Hilfe weiterer Vorlagen in den noch nicht belichteten, abgedeckten Schichtbereichen bildmäßig belichtet und dann mittels eines wäßrig-alkalischen Entwicklers entwickelt.